# EUROPEAN PATENT APPLICATION

(11) **EP 4 589 633 A1**
(43) Date of publication of application: **23.07.2025**
(21) Application number: 24866648.9
(22) Date of filing: 30.09.2024

(54) **METHOD FOR MANUFACTURING SOLAR CELL, AND SOLAR CELL AND CELL ASSEMBLY**

(30) Priority: 08.10.2023 CN 202311296304
(71) Applicant: Longi Solar Technology (Xi'an) Co., Ltd., Xi'an, Shaanxi 710000 (CN)
(72) Inventor: LI, Zhenguo, Xi'an, Shaanxi 710000 (CN); DANG, Jietao, Xi'an, Shaanxi 710000 (CN)
(74) Representative: Grünecker Patent- und Rechtsanwälte PartG mbB
(86) International application number: PCT/CN2024/122949
(87) International publication number: WO 2025/077655

(57) **Abstract**

The present application discloses a method for manufacturing a solar cell, a solar cell, and a solar cell module. The method for manufacturing a solar cell includes: forming an emitter layer on a surface of a semiconductor substrate, where a conductivity type of the semiconductor substrate is opposite to a conductivity type of the emitter layer; forming a passivation layer on the emitter layer; forming an insulating layer on the passivation layer; forming a plurality of busbars on the insulating layer, where the plurality of bus bars extend in a first direction and are arranged at intervals in a second direction, the first direction being different from the second direction; and forming a plurality of fingers on the insulating layer, where the plurality of fingers extend in the second direction and are arranged at intervals in the first direction, where the plurality of busbars extend toward the emitter layer, a depth of the plurality of busbars extending into the passivation layer being not greater than 90% of a thickness of the passivation layer, and a depth of the plurality of busbars extending into the insulating layer being greater than 20% of a thickness of the insulating layer.

## Description

### CROSS-REFERENCE TO RELATED APPLICATIONS

The present application claims priority and benefits to Chinese Patent Application No. 202311296304.2, filed on October 8, 2023, which is incorporated herein by reference in its entirety.

### TECHNICAL FIELD

The present application relates to the technical field of solar cells, and in particular, to a method for manufacturing a solar cell, a solar cell, and a solar cell module.

### BACKGROUND

A solar cell is a semiconductor device that can convert sunlight into electric energy. Specifically, when the solar cell is irradiated with light, a semiconductor substrate included in the solar cell absorbs photos and generates electron-hole pairs. The electron-hole pairs are separated under an effect of a built-in electric field of a PN junction, are led out through an emitter and a back field of the solar cell respectively, and are finally collected by electrode structures arranged on the semiconductor substrate.

The foregoing electrode structures generally include a plurality of busbars and a plurality of fingers that are integrally printed. During sintering, as erosion synchronously proceeds, both the plurality of busbars and the plurality of fingers come into contact with a silicon substrate.

However, in a process in which the plurality of busbars come into contact with the silicon substrate, a passivation layer is seriously damaged. In this case, an open circuit voltage (Uoc) is reduced, affecting photoelectric conversion efficiency.

### SUMMARY

An objective of the present application is to provide a method for manufacturing a solar cell, a solar cell, and a solar cell module, to reduce or eliminate damage to a passivation layer, and improve an open circuit voltage, thereby reducing impact on photoelectric conversion efficiency.

To achieve the foregoing objective, according to a first aspect, the present application provides a method for manufacturing a solar cell. The method for manufacturing a solar cell includes:

first, providing a semiconductor substrate; next, forming an emitter layer on a surface of the semiconductor substrate, where a conductivity type of the semiconductor substrate is opposite to a conductivity type of the emitter layer; next, forming a passivation layer on the emitter layer; next, forming an insulating layer on the passivation layer; next, forming a plurality of busbars on the insulating layer, where the plurality of busbars extend in a first direction and are arranged at intervals in a second direction, the first direction being different from the second direction; and next, forming a plurality of fingers on the insulating layer, where the plurality of fingers extend in the second direction and are arranged at intervals in the first direction, each of the plurality of busbars intersecting with respective fingers of the plurality of fingers, and the plurality of fingers penetrating the passivation layer and the insulating layer to be connected to the emitter layer, where the plurality of busbars extend toward the emitter layer, a depth of the plurality of busbars extending into the passivation layer being not greater than 90% of a thickness of the passivation layer, and a depth of the plurality of busbars extending into the insulating layer being greater than 20% of a thickness of the insulating layer, a depth direction, a thickness direction of the passivation layer, and a thickness direction of the insulating layer being consistent with a direction facing the semiconductor substrate.

In the method for manufacturing a solar cell provided in the present application, the plurality of busbars are formed on the insulating layer. The plurality of busbars extends toward the emitter layer. The depth of the plurality of busbars extending into the passivation layer is not greater than 90% of the thickness of the passivation layer, and the depth of the plurality of busbars extending into the insulating layer is greater than 20% of the thickness of the insulating layer. In this case, a part of the busbars (that is, a partial region of the busbars) after the extension may be formed in only the insulating layer, or may be formed in both the insulating layer and the passivation layer, but the depth of the plurality of busbars extending into the passivation layer is not greater than 90% of the thickness of the passivation layer.

When the part of the plurality of busbars after the extension is formed in only the insulating layer, the plurality of busbars does not damage the passivation layer, thereby ensuring a passivation effect of the passivation layer. Based on this, an open circuit voltage can be improved, thereby reducing or avoiding impact on photoelectric conversion efficiency.

When the part of the plurality of busbars after the extension is formed in both the insulating layer and the passivation layer but the depth of the plurality of busbars extending into the passivation layer is not greater than 90% of the thickness of the passivation layer, compared with a case in the prior art in which the plurality of busbars penetrates the passivation layer and is connected to a silicon substrate, a damage degree of the plurality of busbars to the passivation layer is reduced, thereby ensuring a passivation effect of the passivation layer. Based on this, an open circuit voltage can be improved, thereby reducing impact on photoelectric conversion efficiency. Further, the plurality of busbars is connected to both the insulating layer and the passivation layer. In this case, mechanical properties of the plurality of busbars can be ensured, and a tensile property of the plurality of busbars can be improved. Based on this, a probability that the plurality of busbars is detached from the solar cell can be reduced or eliminated, thereby ensuring quality and performance of the solar cell.

In an embodiment, a ratio of the depth of the plurality of busbars extending into the passivation layer to the thickness of the passivation layer is greater than or equal to 20%.

When the foregoing technical solution is used, the plurality of busbars is connected to both the insulating layer and the passivation layer. In this case, the mechanical properties of each of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell.

In an embodiment, the depth of the plurality of busbars extending into the passivation layer is 0.

When the foregoing technical solution is used, the plurality of busbars cannot damage the passivation layer, thereby ensuring the passivation effect of the passivation layer. Based on this, the open circuit voltage can be improved, thereby avoiding impact on the photoelectric conversion efficiency.

In an embodiment, when the thickness of the passivation layer is greater than or equal to 5 nm and less than or equal to 20 nm, the depth of the plurality of busbars extending into the passivation layer is greater than or equal to 1 nm and less than or equal to 18 nm.

When the foregoing technical solution is used, the depth is greater than or equal to 1 nm. In this case, it can be ensured that the plurality of busbars is connected to both the insulating layer and the passivation layer. Based on this, the mechanical properties of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell. Further, the depth is less than or equal to 18 nm. In this case, the damage degree of the plurality of busbars to the passivation layer can be reduced, thereby ensuring the passivation effect of the passivation layer. In this way, the open circuit voltage is improved, thereby reducing impact on the photoelectric conversion efficiency.

In an embodiment, the thickness of the insulating layer is greater than or equal to 40 nm and less than or equal to 100 nm.

In an embodiment, the plurality of busbars includes a busbar connecting line and a plurality of pads; the plurality of pads are arranged at intervals on the busbar connecting line in the first direction; and a width of the plurality of pads is greater than a width of the busbar connecting line, a width direction of the plurality of pads and a width direction of the busbar connecting line being consistent with the second direction.

When the foregoing technical solution is used, for the same quantity of the busbar connecting lines, compared with a case in which the width of the busbar connecting line is equal to the width of the plurality of pads, a quantity of raw materials used for manufacturing the busbar connecting lines can be reduced while a current collection capability of the busbar connecting lines satisfies an actual requirement, thereby reducing raw material costs. In addition, blocking on the semiconductor substrate by the busbar connecting line can also be reduced, and a light-receiving area of the semiconductor substrate can be increased, thereby improving the photoelectric conversion efficiency of the solar cell. Further, during subsequent manufacturing of the solar cell module, a welding strip needs to be connected to the pad. In this case, compared with the case in which the width of the busbar connecting line is equal to the width of the plurality of pads, the plurality of welding strips is more easily connected to the plurality of pads, thereby reducing manufacturing difficulty, and improving manufacturing efficiency.

In an embodiment, a quantity of the plurality of busbars is greater than or equal to 8 and less than or equal to 25; and/or the width of the busbar connecting line is greater than or equal to 35 µm and less than or equal to 60 µm, and the width of the plurality of pads is greater than or equal to 0.6 mm and less than or equal to 1.3 mm.

When the foregoing technical solution is used, the quantity of the plurality of busbars, the width of the busbar connecting line, and the width of the plurality of pads are controlled, so that an area of blocking the semiconductor substrate by the plurality of busbars can be controlled. In this case, the amount of light injected into the semiconductor substrate can be increased, and the light-receiving area of the semiconductor substrate can be increased, thereby improving solar cell efficiency of the solar cell.

In an embodiment, a quantity of the plurality of fingers is greater than or equal to 100 and less than or equal to 200; and a width of the plurality of fingers is greater than or equal to 20 µm and less than or equal to 45 µm, a width direction of the plurality of fingers being consistent with the first direction.

When the foregoing technical solution is used, a current collection capability of the plurality of fingers can be improved, thereby improving the solar cell efficiency of the solar cell.

In an embodiment, the forming a plurality of busbars on the insulating layer includes: first, printing busbar raw materials on the insulating layer, to form a plurality of initial busbars; and next, processing the plurality of initial busbars, to form the plurality of busbars, where a ratio of a width of the plurality of busbars to a width of the plurality of initial busbars is greater than 1 and less than or equal to 1.1, a width direction of the plurality of busbars and a width direction of the plurality of initial busbars being consistent with the second direction.

When the foregoing technical solution is used, an extending size of the plurality of finally formed busbars in the second direction is controlled. In this way, negative impact on the insulating layer and/or the passivation layer can be reduced, thereby reducing negative impact on an anti-reflection effect of the solar cell and/or the passivation effect. In addition, blocking on the semiconductor substrate by the plurality of busbars can also be reduced, and a light-receiving area of the semiconductor substrate can be increased, thereby improving the photoelectric conversion efficiency of the solar cell.

In an embodiment, the forming a plurality of fingers on the insulating layer includes: first, printing finger raw materials on the insulating layer, to form a plurality of initial fingers; and next, processing the plurality of initial fingers, to form the plurality of fingers, where a ratio of a width of the plurality of fingers to a width of the plurality of initial fingers is greater than 1 and less than or equal to 1.2, a width direction of the plurality of fingers and a width direction of the plurality of initial fingers being consistent with the first direction.

When the foregoing technical solution is used, an extending size of the plurality of finally formed fingers in the second direction is controlled. In this way, negative impact on the insulating layer and/or the passivation layer can be reduced, thereby reducing negative impact on the anti-reflection effect of the solar cell and/or the passivation effect. In addition, blocking on the semiconductor substrate by the plurality of fingers can also be reduced, and the light-receiving area of the semiconductor substrate can be increased, thereby improving the photoelectric conversion efficiency of the solar cell.

In an embodiment, a metal solid content of the busbar raw materials is less than a metal solid content of the finger raw materials.

When the foregoing technical solution is used, a depth of the plurality of busbars extending toward the emitter layer is less than a depth of the plurality of fingers extending toward the emitter layer. In this case, the damage degree of the plurality of busbars to the passivation layer can be reduced, thereby ensuring the passivation effect of the passivation layer. Further, when the metal solid content of the finger raw material remains unchanged, compared with a case in the prior art in which the metal solid content of the busbar raw material is the same as the metal solid content of the finger raw material, costs of the busbar raw materials can be reduced, thereby reducing manufacturing costs for manufacturing the solar cell. In addition, it can also be further ensured that the depth of the plurality of fingers extending toward the emitter layer in the present application is substantially the same as or is the same as the depth of the plurality of fingers extending toward the emitter layer in the prior art, thereby ensuring that performance of the plurality of fingers remains unchanged.

According to a second aspect, the present application further provides a solar cell. The solar cell includes: a semiconductor substrate, an emitter layer, a passivation layer, an insulating layer, a plurality of busbars, and a plurality of fingers. The emitter layer is formed on a surface of the semiconductor substrate, where a conductivity type of the semiconductor substrate is opposite to a conductivity type of the emitter layer. The passivation layer is formed on the emitter layer. The insulating layer is formed on the passivation layer. The plurality of busbars are formed on the insulating layer, where the plurality of busbars extend in a first direction and are arranged at intervals in a second direction, the first direction being different from the second direction. The plurality of fingers are formed on the insulating layer, where the plurality of fingers extend in the second direction and are arranged at intervals in the first direction, each of the plurality of busbars intersecting with respective fingers of the plurality of fingers, and the plurality of fingers penetrating the passivation layer and the insulating layer to be connected to the emitter layer. The plurality of busbars extend toward the emitter layer, a depth of the plurality of busbars extending into the passivation layer being not greater than 90% of a thickness of the passivation layer, and a depth of the plurality of busbars extending into the insulating layer being greater than 20% of a thickness of the insulating layer, a depth direction, a thickness direction of the passivation layer, and a thickness direction of the insulating layer being consistent with a direction facing the semiconductor substrate.

In the solar cell provided in the present application, the plurality of busbars are formed on the insulating layer. the plurality of busbars extends toward the emitter layer. The depth of the plurality of busbars extending into the passivation layer is not greater than 90% of the thickness of the passivation layer, and the depth of the plurality of busbars extending into the insulating layer is greater than 20% of the thickness of the insulating layer. In this case, a part of the plurality of busbars (that is, a partial region of the plurality of busbars) after the extension may be formed in only the insulating layer, or may be formed in both the insulating layer and the passivation layer, but the depth of the plurality of busbars extending into the passivation layer is not greater than 90% of the thickness of the passivation layer.

When the part of the plurality of busbars after the extension is formed in only the insulating layer, the plurality of busbars does not damage the passivation layer, thereby ensuring a passivation effect of the passivation layer. Based on this, an open circuit voltage can be improved, thereby reducing or avoiding impact on photoelectric conversion efficiency.

When the part of the plurality of busbars after the extension is formed in both the insulating layer and the passivation layer but the depth of the plurality of busbars extending into the passivation layer is not greater than 90% of the thickness of the passivation layer, compared with a case in the prior art in which the plurality of busbars penetrates the passivation layer and is connected to a silicon substrate, a damage degree of the plurality of busbars to the passivation layer is reduced, thereby ensuring a passivation effect of the passivation layer. Based on this, an open circuit voltage can be improved, thereby reducing impact on photoelectric conversion efficiency. Further, the plurality of busbars is connected to both the insulating layer and the passivation layer. In this case, mechanical properties of the plurality of busbars can be ensured, and a tensile property of the plurality of busbars can be improved. Based on this, a probability that the plurality of busbars is detached from the solar cell can be reduced or eliminated, thereby ensuring quality and performance of the solar cell.

In an embodiment, the emitter layer is formed on a back surface of the solar cell.

In an embodiment, the emitter layer is formed by doping in an original structure of the semiconductor substrate, or is formed by performing a deposition process on the surface of the semiconductor substrate.

In an embodiment, a ratio of the depth of the plurality of busbars extending into the passivation layer to the thickness of the passivation layer is greater than or equal to 20%.

When the foregoing technical solution is used, the plurality of busbars is connected to both the insulating layer and the passivation layer. In this case, the mechanical properties of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell.

In an embodiment, the depth of the plurality of busbars extending into the passivation layer is 0.

When the foregoing technical solution is used, the plurality of busbars cannot damage the passivation layer, thereby ensuring the passivation effect of the passivation layer. Based on this, the open circuit voltage can be improved, thereby avoiding impact on the photoelectric conversion efficiency.

In an embodiment, when the thickness of the passivation layer is greater than or equal to 5 nm and less than or equal to 20 nm, the depth of the plurality of busbars extending into the passivation layer is greater than or equal to 1 nm and less than or equal to 18 nm.

When the foregoing technical solution is used, the depth is greater than or equal to 1 nm. In this case, it can be ensured that the plurality of busbars is connected to both the insulating layer and the passivation layer. Based on this, the mechanical properties of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell. Further, the depth is less than or equal to 18 nm. In this case, the damage degree of the plurality of busbars to the passivation layer can be reduced, thereby ensuring the passivation effect of the passivation layer. In this way, the open circuit voltage is improved, thereby reducing impact on the photoelectric conversion efficiency.

In an embodiment, the thickness of the insulating layer is greater than or equal to 40 nm and less than or equal to 100 nm.

In an embodiment, the plurality of busbars includes a busbar connecting line and a plurality of pads; the plurality of pads are arranged at intervals on the busbar connecting line in the first direction; and a width of the plurality of pads is greater than a width of the busbar connecting line, a width direction of the plurality of pads and a width direction of the busbar connecting line being consistent with the second direction.

When the foregoing technical solution is used, for the same quantity of the busbar connecting lines, compared with a case in which the width of the busbar connecting line is equal to the width of the plurality of pads, a quantity of raw materials used for manufacturing the busbar connecting lines can be reduced while a current collection capability of the busbar connecting lines satisfies an actual requirement, thereby reducing raw material costs. In addition, blocking on the semiconductor substrate by the busbar connecting line can also be reduced, and a light-receiving area of the semiconductor substrate can be increased, thereby improving the photoelectric conversion efficiency of the solar cell. Further, during subsequent manufacturing of the solar cell module, a welding strip needs to be connected to the pad. In this case, compared with the case in which the width of the busbar connecting line is equal to the width of the plurality of pads, the plurality of welding strips is more easily connected to the plurality of pads, thereby reducing manufacturing difficulty, and improving manufacturing efficiency.

In an embodiment, a quantity of the plurality of busbars is greater than or equal to 8 and less than or equal to 25; and/or the width of the busbar connecting line is greater than or equal to 35 µm and less than or equal to 60 µm, and the width of the plurality of pads is greater than or equal to 0.6 mm and less than or equal to 1.3 mm.

When the foregoing technical solution is used, the quantity of the plurality of busbars, the width of the busbar connecting line, and the width of the plurality of pads are controlled, so that an area of blocking the semiconductor substrate by the plurality of busbars can be controlled. In this case, the amount of light injected into the semiconductor substrate can be increased, and the light-receiving area of the semiconductor substrate can be increased, thereby improving solar cell efficiency of the solar cell.

In an embodiment, a quantity of the plurality of fingers is greater than or equal to 100 and less than or equal to 200; and a width of the plurality of fingers is greater than or equal to 20 µm and less than or equal to 45 µm, a width direction of the plurality of fingers being consistent with the first direction.

When the foregoing technical solution is used, a current collection capability of the plurality of fingers can be improved, thereby improving the solar cell efficiency of the solar cell.

According to a third aspect, the present application further provides a solar cell module. The solar cell module includes a plurality of welding strips, and a plurality of solar cells in the foregoing technical solutions that are arranged at intervals, where the plurality of welding strips is connected to respective busbars of a plurality of busbars.

Compared with the prior art, beneficial effects of the solar cell module provided in the present application are the same as the beneficial effects of the solar cell in the foregoing technical solutions. Details are not described herein again.

In an embodiment, when the plurality of busbars includes a busbar connecting line and a plurality of pads, the plurality of welding strips is arranged on the plurality of pads in the first direction and covers the busbar connecting line; a maximum width of the plurality of welding strips is less than or equal to the width of the plurality of pads; and a width direction of the plurality of welding strips and the width direction of the plurality of pads are consistent with the second direction.

When the foregoing technical solution is used, blocking on the semiconductor substrate by the plurality of welding strips can be reduced, and the light-receiving area of the semiconductor substrate can be increased, thereby improving the photoelectric conversion efficiency of the solar cell.

In an embodiment, a width of the plurality of welding strips is less than or equal to the width of the busbar connecting line, the width direction of the plurality of welding strips and the width direction of the busbar connecting line being consistent with the second direction.

When the foregoing technical solution is used, blocking on the semiconductor substrate by the plurality of welding strips can be reduced, and the light-receiving area of the semiconductor substrate can be increased, thereby improving the photoelectric conversion efficiency of the solar cell.

In an embodiment, a ratio of the width of the plurality of welding strips to the width of the busbar connecting line is greater than or equal to 50% and less than or equal to 90%.

When the foregoing technical solution is used, the plurality of welding strips includes a core layer made of a metal material and a solder layer formed on an outer surface of the core layer; in an actual process of welding the plurality of welding strips to the plurality of pads, the solder layer melts due to heat and has flowability; and because the foregoing ratio is greater than or equal to 50% and less than or equal to 90%, flowing solders can be distributed at an interface of the plurality of welding strips and the busbar connecting line, to provide sufficient flow space. In this case, the solders cannot flow to the semiconductor substrate, to prevent the solders from polluting and blocking the semiconductor substrate, thereby ensuring the quality and the performance of the solar cell.

### BRIEF DESCRIPTION OF THE DRAWINGS

Accompanying drawings described herein are used for providing a further understanding of the present application, and form part of the present application. Exemplary embodiments of the present application and descriptions thereof are used for explaining the present application, and do not constitute any inappropriate limitation to the present application. In the accompanying drawings:
FIG. 1 is a schematic structural diagram of a solar cell in the prior art;
FIG. 2 is a schematic structural diagram 1 of a solar cell according to an embodiment of the present application; and
FIG. 3 is a schematic structural diagram 2 of a solar cell according to an embodiment of the present application.

**Reference numerals:**

| | | |
|---|---|---|
| 1-semiconductor substrate; | 2-emitter layer; | 3-passivation layer; |
| 4-insulating layer; | 5-busbar; | 50-busbar connecting line; |
| 51-pad; | 6-finger. | |

### DETAILED DESCRIPTION

To make the technical problems to be resolved in the present application, the technical solutions, and beneficial effects more comprehensible, the following further describes the present application in detail with reference to the accompanying drawings and embodiments. It should be understood that, the specific embodiments described herein are merely used to explain the present application but are not intended to limit the present application.

It should be noted that, when an element is referred to as "being fixed to" or "being arranged on" another element, the element may be directly on another element, or may be indirectly on another element. When an element is referred to as "being connected to" another element, the element may be directly connected to another element, or may be indirectly connected to another element.

In addition, the terms "first" and "second" are used for descriptive objectives only and are not to be construed as indicating or implying relative importance or implicitly indicating the number of technical features indicated. Therefore, a feature defined by "first" or "second" may explicitly or implicitly include one or more features. In the description of the present application, unless otherwise explicitly and specifically limited, "a plurality of" means two or more; and unless otherwise explicitly and specifically limited, "at least one" means one or more than one.

In the description of the present application, it should be understood that, orientation or position relationships indicated by the terms such as "upper", "lower", "front", "rear", "left", and "right" are based on orientation or position relationships shown in the accompanying drawings, and are used only for ease and brevity of illustration and description of the present application, rather than indicating or implying that the mentioned apparatus or element needs to have a particular orientation or needs to be constructed and operated in a particular orientation. Therefore, such terms should not be construed as limiting of the present application.

In the description of the present application, it should be noted that, unless otherwise explicitly specified or limited, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two elements, or an interaction relationship between two elements. A person of ordinary skill in the art may understand the specific meanings of the foregoing terms in the present application according to specific situations.

Screen printing is a core of process management in a process of manufacturing and producing a solar cell. Screen printing is mainly applied to formation of an electrode of the solar cell. Specifically, printing is performed by using a basic principle that a paste is permeable to meshes of a patterned part of a screen and the paste is not permeable to meshes of a non-patterned part of the screen. During printing, the paste is poured into one end of the screen, a certain pressure is applied to a paste portion on the screen by using a scraper, and at the same time, the scraper moves toward the other end of the screen. During movement, the paste is extruded by the scraper from the meshes of the patterned part to a substrate, to form a required pattern. Conventional screen printing for the solar cell uses a mainstream single print (SP) mode, that is, a busbar-finger integral printing mode. In a screen design, both busbars and fingers are considered, and after a single print process of the paste, busbar lines and finger lines are overlapped. After the printing, the paste comes into contact with an insulating layer (for example, SiNx). A phosphate glass element included in the paste has erosion, and erodes SiNx and a lower passivation layer (for example, AlOx) on a contact surface, so that Ag and Si in the paste form a silver-silicon alloy, thereby coming into good Ohmic contact.

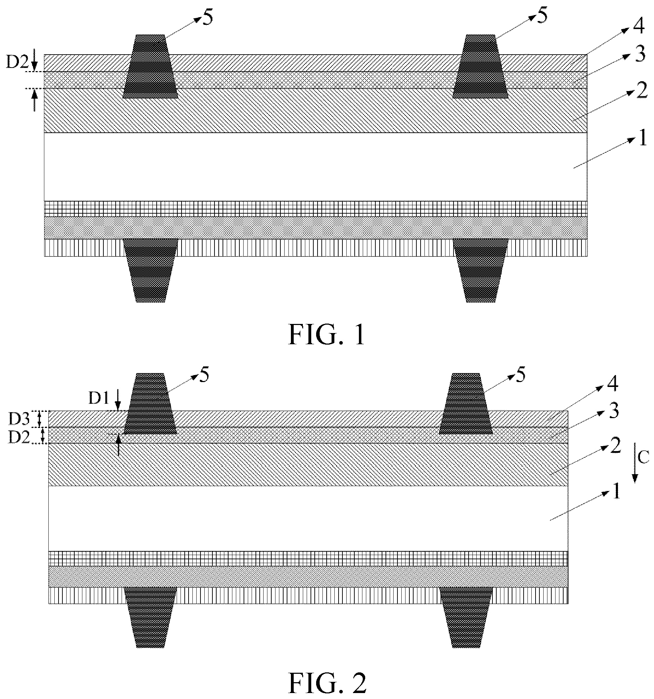

Specifically, in a conventional procedure of manufacturing and forming a screen-printed electrode, a solar cell on which single integral paste printing has been completed enters a sintering furnace. A first stage of sintering is performed in a temperature zone of 200°C to 400°C, and at this stage, organic binders, for example, ethyl cellulose and polyvinyl alcohol are to be burned off. A second stage of the sintering is performed at 600°C to 900°C, and this stage is an important operation for forming the electrode. At this stage, the phosphate glass frit is converted from a solid state to a melted state at a high temperature, so that the insulating layer (for example, SiNx) can be eroded, thereby widening a window; the phosphate glass frit carries silver particles in a metal conduction phase to move forward, and melts and erodes a lower medium film (for example, AlOx); and the silver particles are melted or have another reaction after being sintered, thereby further coming into contact with the lower film layer. In this process, busbars formed by SP integral printing also erode the lower layer, and penetrate the insulating layer and the passivation layer (where a thickness of the passivation layer is generally greater than or equal to 5 nm and less than or equal to 20 nm), and a final residence depth of the plurality of busbars is consistent with a residence depth of a plurality of fingers. In other words, during the sintering, as erosion synchronously proceeds, both the plurality of busbars and the plurality of fingers come into contact with a silicon substrate. However, in a process in which the plurality of busbars come into contact with the silicon substrate, the passivation layer is seriously damaged. In this case, an open circuit voltage (Uoc) is reduced, affecting photoelectric conversion efficiency. Referring to FIG. 1, a plurality of busbars 5 come into contact with an emitter layer 2 on a silicon substrate (namely, a semiconductor substrate 1). In this case, the open circuit voltage (Uoc) is reduced, affecting the photoelectric conversion efficiency. It should be noted that, the emitter layer 2 may be formed by doping in an original structure of a monocrystalline silicon semiconductor substrate, for example, may be formed by using a common method in the industry such as diffusion or ion injection, or may be an additional layer formed by performing a deposition process such as LPCVD or PECVD on a surface of the original monocrystalline silicon semiconductor substrate.

To resolve the foregoing technical problems, according to a first aspect, an embodiment of the present application provides a method for manufacturing a solar cell. The method for manufacturing a solar cell includes the following operations.

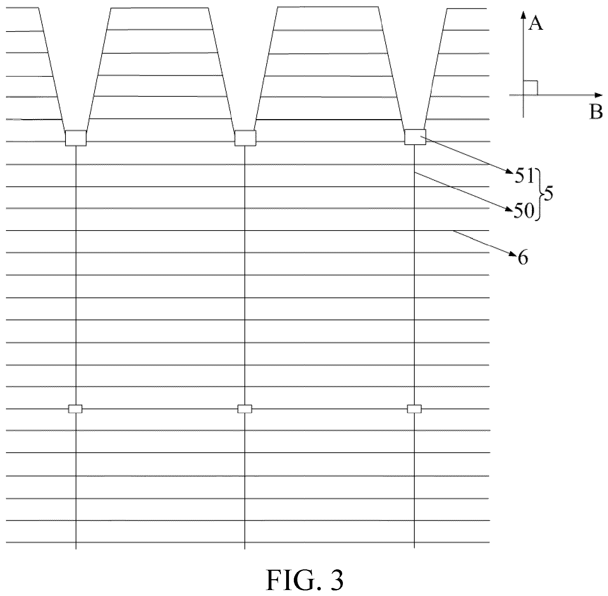

Referring to FIG. 2 and FIG. 3, a semiconductor substrate 1 is first provided.

During actual application, a specific structure of the semiconductor substrate may be determined according to an actual application scenario, which is not specifically limited herein. In an exemplary embodiment, the semiconductor substrate may be only a semiconductor base. In an exemplary embodiment, the semiconductor base may be a base made of a semiconductor material, for example, a monocrystalline silicon base, a polycrystalline silicon base, or an amorphous silicon base. In terms of conductivity types, the semiconductor base may be an N-type conducting base or a P-type conducting base. In terms of structures, a first surface of the semiconductor base may be a textured surface, to improve a light-trapping effect of a light-receiving surface of the solar cell, thereby improving utilization on light by the solar cell. Certainly, the first surface of the semiconductor base may alternatively be a plane. A second surface of the semiconductor base may be a polished surface or a textured surface, which is not specifically limited herein. Further, the semiconductor substrate may be, for example, a rectangular semiconductor substrate in a size of 182, 210, or the like. A thickness of the semiconductor substrate is generally greater than or equal to 100 µm and less than or equal to 180 µm.

Next, an emitter layer 2 is formed on a surface of the semiconductor substrate 1, where a conductivity type of the semiconductor substrate 1 is opposite to a conductivity type of the emitter layer 2, and the emitter layer 2 and the semiconductor substrate 1 jointly form a PN junction.

In an exemplary embodiment, the emitter layer is a region doped with impurities of a second conductivity type (for example, N-type) opposite to a first conductivity type (for example, P-type) of the semiconductor substrate. Further, the emitter layer may be formed by doping in an original structure of a monocrystalline silicon semiconductor substrate, for example, may be formed by using a common method in the industry such as diffusion or ion injection, or may be an additional layer formed by performing a deposition process or the like on a surface of the original monocrystalline silicon semiconductor substrate. Still further, the emitter layer is formed on a light-receiving surface of the semiconductor substrate. In addition, for other descriptions about the emitter layer, reference may be made to the prior art, which is not specifically limited herein.

Next, a passivation layer 3 is formed on the emitter layer 2.

In an exemplary embodiment, a material of the passivation layer 3 includes one or more of aluminum oxide, zinc oxide, and silicon nitride.

Next, an insulating layer 4 is formed on the passivation layer 3.

In an exemplary embodiment, a material of the insulating layer 4 includes one or more of silicon oxide, silicon nitride, and silicon oxynitride.

Next, a plurality of busbars 5 are formed on the insulating layer 4, where the plurality of busbars 5 extend in a first direction and are arranged at intervals in a second direction. The first direction is different from the second direction.

In an exemplary embodiment, the first direction and the second direction may be any two directions parallel to the surface of the semiconductor substrate and different from each other. Preferably, referring to FIG. 3, a first direction A and a second direction B are orthogonal.

Next, a plurality of fingers 6 are formed on the insulating layer 4, where the plurality of fingers 6 extend in the second direction and are arranged at intervals in the first direction, each of the plurality of busbars 5 intersecting with respective fingers 6 of the plurality of fingers 6, and the plurality of fingers 6 penetrating the passivation layer 3 and the insulating layer 4 to be connected to the emitter layer 2.

In an exemplary embodiment, in a direction facing the semiconductor substrate 1, the plurality of fingers is connected to the emitter layer through an opening on the passivation layer and the insulating layer, or through a through hole on the passivation layer and the insulating layer, or in another manner, e.g., a deposition process such as PVD or DVD, or may be electroplating. It should be understood that, as long as the plurality of fingers can be connected to the emitter layer, a connection manner is not limited to the foregoing description.

the plurality of busbars 5 extends in a direction C of the emitter layer 2. A depth D1 of the plurality of busbars 5 extending into the passivation layer 3 is not greater than 90% of a thickness D2 of the passivation layer 3, and a depth D1 of the plurality of busbars 5 extending into the insulating layer 4 is greater than 20% of a thickness D3 of the insulating layer 4, a depth direction, a thickness direction of the passivation layer 3, and a thickness direction of the insulating layer 4 being consistent with the direction facing the semiconductor substrate 1. In an exemplary embodiment, the depth of the plurality of busbars 5 extending into the passivation layer 3 may be 0%, 10%, 15%, 30%, 50%, 80%, or 90% of the thickness of the passivation layer 3.

In the method for manufacturing a solar cell provided in this embodiment of the present application, the plurality of busbars 5 are formed on the insulating layer 4. the plurality of busbars 5 extends toward the emitter layer 2. The depth of the plurality of busbars 5 extending into the passivation layer is not greater than 90% of the thickness of the passivation layer 3, and the depth of the plurality of busbars 5 extending into the insulating layer is greater than 20% of the thickness of the insulating layer. In this case, a part of the plurality of busbars 5 (i.e., a partial region of the plurality of busbars) after the extension may be formed in only the insulating layer 4, or may be formed in both the insulating layer 4 and the passivation layer 3, but the depth of the plurality of busbars 5 extending into the passivation layer is not greater than 90% of the thickness of the passivation layer 3.

When the part of the plurality of busbars 5 after the extension is formed in only the insulating layer 4, the plurality of busbars 5 does not damage the passivation layer 3, thereby ensuring a passivation effect of the passivation layer 3. Based on this, an open circuit voltage can be improved, thereby reducing or avoiding impact on photoelectric conversion efficiency.

When the part of the plurality of busbars 5 after the extension is formed in both the insulating layer 4 and the passivation layer 3 but the depth of the plurality of busbars 5 extending into the passivation layer is not greater than 90% of the thickness of the passivation layer 3, compared with a case in the prior art in which the plurality of busbars 5 penetrates the passivation layer 3 and is connected to a silicon substrate, a damage degree of the plurality of busbars 5 to the passivation layer 3 is reduced, thereby ensuring a passivation effect of the passivation layer 3. Based on this, an open circuit voltage can be improved, thereby reducing impact on photoelectric conversion efficiency. Further, when an electrical connection is established in a subsequently manufactured solar cell module, a welding strip covers the plurality of busbars 5. Mechanical influences (including but not limited to mismatched stress and expansion coefficient, and the like) brought by the plurality of welding strips are disadvantageous to the plurality of busbars 5 (for example, the plurality of busbars 5 is detached from the solar cell accordingly). When the part of the plurality of busbars 5 after the extension is formed in both the insulating layer 4 and the passivation layer 3 but the depth of the plurality of busbars 5 extending into the passivation layer is not greater than 90% of the thickness of the passivation layer 3, the plurality of busbars 5 is connected to both the insulating layer 4 and the passivation layer 3. In this case, mechanical properties of the plurality of busbars 5 can be ensured, and a tensile property of the plurality of busbars 5 can be improved. Based on this, a probability that the plurality of busbars 5 is detached from the solar cell can be reduced or eliminated, thereby ensuring quality and performance of the solar cell.

In an optional embodiment, the solar cell may be a back contact solar cell. In the back contact solar cell, the emitter layer is formed on a back surface of the solar cell. The emitter layer includes a dope type opposite to a dope type of the semiconductor substrate. The emitter layer may be formed by doping in the original structure of the semiconductor substrate, or may be formed by performing an additional deposition process such as LPCVD or PECVD.

In an embodiment, referring to FIG. 2, a ratio of the depth of the plurality of busbars 5 extending into the passivation layer 3 to the thickness of the passivation layer 3 is greater than or equal to 20%. In an exemplary embodiment, the ratio may be 20%, 30%, 35%, 46%, or 50%. In this case, the plurality of busbars 5 is connected to both the insulating layer 4 and the passivation layer 3. Based on this, the mechanical properties of the plurality of busbars 5 can be ensured, and the tensile property of the plurality of busbars 5 can be improved. In this way, the probability that the plurality of busbars 5 is detached from the solar cell is reduced or eliminated, thereby ensuring the quality and the performance of the solar cell.

With reference to the foregoing descriptions, after the plurality of busbars 5 extends in the passivation layer 3, the ratio of the depth of the plurality of busbars 5 extending into the passivation layer 3 to the thickness of the passivation layer 3 is greater than or equal to 20% and less than or equal to 90%.

In an embodiment, the depth of the plurality of busbars 5 extending into the passivation layer 3 is 0. In other words, the plurality of busbars 5 is formed on only the insulating layer 4. Specifically, the plurality of busbars 5 is formed inside only the insulating layer 4, or the plurality of busbars 5 is formed on a junction of the insulating layer 4 and the passivation layer 3, or the plurality of busbars 5 is formed on only a surface of the insulating layer 4. In this case, the plurality of busbars 5 cannot damage the passivation layer 3, thereby ensuring the passivation effect of the passivation layer 3. Based on this, the open circuit voltage can be improved, thereby avoiding impact on the photoelectric conversion efficiency.

In an embodiment, when the thickness of the passivation layer is greater than or equal to 5 nm and less than or equal to 20 nm, the depth of the plurality of busbars extending into the passivation layer is greater than or equal to 1 nm and less than or equal to 18 nm. In an exemplary embodiment, the depth of the plurality of busbars extending into the passivation layer may be 1 nm, 5 nm, 9 nm, 13 nm, 15 nm, or 18 nm.

The depth is greater than or equal to 1 nm. In this case, it can be ensured that the plurality of busbars is connected to both the insulating layer and the passivation layer. Based on this, the mechanical properties of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell. Further, the depth is less than or equal to 18 nm. In this case, the damage degree of the plurality of busbars to the passivation layer can be reduced, thereby ensuring the passivation effect of the passivation layer. In this way, the open circuit voltage is improved, thereby reducing impact on the photoelectric conversion efficiency. In addition, it can be ensured that the thickness of the passivation layer greater than 2 mm is not damaged.

In an embodiment, the emitter layer includes heavily-doped regions and lightly-doped regions. Fingers are connected to the heavily-doped regions, to form alloy regions. A depth of the alloy regions extending into the emitter layer is less than a junction depth of an emitter of the emitter layer, and a depth direction and a junction depth direction of the emitter are consistent with the direction facing the semiconductor substrate.

In an optional manner, when the junction depth of the emitter is greater than or equal to 300 nm and less than or equal to 1200 nm, the depth of the alloy regions extending into the emitter layer is greater than or equal to 50 nm and less than or equal to 1000 nm. In an exemplary embodiment, the depth of the alloy regions extending into the emitter layer may be 50 nm, 80 nm, 100 nm, 260 nm, 390 nm, 550 nm, or 1000 nm. The depth is greater than or equal to 50 nm. In this case, the plurality of fingers and the semiconductor substrate may be allowed to form an alloy, thereby coming into good Ohmic contact.

Preferably, when the junction depth of the emitter is greater than or equal to 300 nm and less than or equal to 1200 nm, the depth of the alloy regions extending into the emitter layer is greater than or equal to 50 nm and less than or equal to 100 nm.

In an embodiment, the thickness of the insulating layer is greater than or equal to 40 nm and less than or equal to 100 nm. In an exemplary embodiment, the thickness of the insulating layer may be 40 nm, 50 nm, 60 nm, 70 nm, 80 nm, 90 nm, or 100 nm.

In an embodiment, referring to FIG. 3, each of the plurality of busbars 5 includes a busbar connecting line 50 and a plurality of pads 51; the plurality of pads 51 are arranged at intervals on the busbar connecting line 50 in the first direction; and a width of the plurality of pads 51 is greater than a width of the busbar connecting line 50, a width direction of the plurality of pads 51 and a width direction of the busbar connecting line 50 being consistent with the second direction.

Referring to FIG. 2 and FIG. 3, for the same quantity of the busbar connecting lines 50, compared with a case in which the width of the busbar connecting line 50 is equal to the width of the plurality of pads 51, a quantity of raw materials used for manufacturing the busbar connecting lines 50 can be reduced while a current collection capability of the busbar connecting lines 50 satisfies an actual requirement, thereby reducing raw material costs. In addition, blocking on the semiconductor substrate 1 by the busbar connecting line 50 can also be reduced, and a light-receiving area of the semiconductor substrate 1 can be increased, thereby improving the photoelectric conversion efficiency of the solar cell. Further, during subsequent manufacturing of the solar cell module, a welding strip needs to be connected to the pad 51. In this case, compared with the case in which the width of the busbar connecting line 50 is equal to the width of the plurality of pads 51, the plurality of welding strips is more easily connected to the plurality of pads 51, thereby reducing manufacturing difficulty, and improving manufacturing efficiency. It should be understood that, for specific structures, manufacturing materials, and the like of the busbar connecting line 50 and the pad 51, reference may be made to the prior art, which are not specifically limited herein.

In an embodiment, referring to FIG. 3, a quantity of the plurality of busbars 5 is greater than or equal to 8 and less than or equal to 25. In an exemplary embodiment, the quantity of the plurality of busbars 5 may be 8, 10, 12, 15, 18, 20, 22, or 25. In addition/alternatively, the width of the busbar connecting line 50 is greater than or equal to 35 µm and less than or equal to 60 µm. In an exemplary embodiment, the width of the busbar connecting line 50 may be 35 µm, 40 µm, 45 µm, 52 µm, 55 µm, or 60 µm. The width of the plurality of pads 51 is greater than or equal to 0.6 mm and less than or equal to 1.3 mm. In an exemplary embodiment, the width of the plurality of pads 51 may be 0.6 mm, 0.8 mm, 1.0 mm, 1.16 mm, 1.23 mm, or 1.3 mm.

The quantity of the plurality of busbars 5, the width of the busbar connecting line, and the width of the plurality of pads are controlled, so that an area of blocking the semiconductor substrate 1 by the plurality of busbars 5 can be controlled. In this case, the amount of light injected into the semiconductor substrate 1 can be increased, and the light-receiving area of the semiconductor substrate 1 can be increased, thereby improving solar cell efficiency of the solar cell.

In an embodiment, referring to FIG. 3, a quantity of the plurality of fingers 6 is greater than or equal to 100 and less than or equal to 200. In an exemplary embodiment, the quantity of the plurality of fingers 6 may be 100, 120, 150, 180, 195, or 200. A width of the plurality of fingers 6 is greater than or equal to 20 µm and less than or equal to 45 µm, and a width direction of the plurality of fingers 6 being consistent with the first direction. In an exemplary embodiment, the width of the plurality of fingers 6 may be 20 µm, 26 µm, 30 µm, 36 µm, 40 µm, or 45 µm. In this case, a current collection capability of the plurality of fingers 6 can be improved, thereby improving the solar cell efficiency of the solar cell.

In an embodiment, the plurality of busbars being formed on the insulating layer includes the following operations.

First, busbar raw materials are printed on the insulating layer, to form a plurality of initial busbars.

In an exemplary embodiment, the busbar raw materials include glass frit and metal. In an exemplary embodiment, the glass frit includes one or more ofPbO, B₂O₃, Na₂O, Li₂O, Bi₂O₃, WO₃, TeO₂, and Te/W. The metal includes, but not limited to, silver. Further, the busbar raw materials may be screen-printed. For a specific printing process, reference may be made to the prior art, which is not specifically limited herein.

Next, the plurality of initial busbars are processed, to form the plurality of busbars.

A ratio of a width of the plurality of busbars to a width of the plurality of initial busbars is greater than 1 and less than or equal to 1.1, a width direction of the plurality of busbars and a width direction of the plurality of initial busbars being consistent with the second direction. In an exemplary embodiment, the ratio may be 1.01, 1.02, 1.04, 1.05, 1.08, 1.09, or 1.1.

In an actual process of manufacturing the plurality of busbars, the plurality of busbars extends toward the emitter layer, and also extends in the second direction. Therefore, an extending size of the plurality of finally formed busbars in the second direction is controlled. In this way, negative impact on the insulating layer and/or the passivation layer can be reduced, thereby reducing negative impact on an anti-reflection effect of the solar cell and/or the passivation effect. In addition, blocking on the semiconductor substrate by the plurality of busbars can also be reduced, and a light-receiving area of the semiconductor substrate can be increased, thereby improving the photoelectric conversion efficiency of the solar cell.

In addition, the plurality of busbars does not extend in the semiconductor substrate. It should be noted that, that the plurality of busbars does not extend in the semiconductor substrate herein means that the metal element (for example, silver) in the busbar raw material does not enter an interface of the semiconductor substrate, or the metal element (for example, silver) in the busbar raw materials does not form an alloy (for example, a silver-silicon alloy) with a semiconductor material in the semiconductor substrate.

Preferably, the ratio of the width of the plurality of busbars to the width of the plurality of initial busbars is greater than 1 and less than or equal to 1.05. In an exemplary embodiment, the ratio may be 1.01, 1.02, 1.03, 1.04, or 1.05.

In an embodiment, the plurality of fingers being formed on the insulating layer includes the following operations.

First, finger raw materials are printed on the insulating layer, to form a plurality of initial fingers.

In an exemplary embodiment, the finger raw materials include glass frit and metal. In an exemplary embodiment, the glass frit includes one or more ofPbO, B₂O₃, Na₂O, Li₂O, Bi₂O₃, WO₃, TeO₂, and Te/W. The metal includes, but not limited to, silver. Further, the finger raw materials may be screen-printed. For a specific printing process, reference may be made to the prior art, which is not specifically limited herein.

Next, the plurality of initial fingers are processed, to form the plurality of fingers.

A ratio of a width of the plurality of fingers to a width of the plurality of initial fingers is greater than 1 and less than or equal to 1.2, a width direction of the plurality of fingers and a width direction of the plurality of initial fingers being consistent with the first direction. In an exemplary embodiment, the ratio may be 1.01, 1.02, 1.04, 1.05, 1.08, 1.09, 1.1, or 1.2.

In an actual process of manufacturing the plurality of fingers, the plurality of fingers extends in the second direction, and erosion of the finger raw material is greater than erosion of the busbar raw material. Therefore, an extending size of the plurality of finally formed fingers in the second direction is controlled. In this way, negative impact on the insulating layer and/or the passivation layer can be reduced, thereby reducing negative impact on an anti-reflection effect of the solar cell and/or the passivation effect. In addition, blocking on the semiconductor substrate by the plurality of fingers can also be reduced, and the light-receiving area of the semiconductor substrate can be increased, thereby improving the photoelectric conversion efficiency of the solar cell.

Further, the plurality of fingers extend in the emitter layer. Under a window effect of phosphate glass, the metal element in the finger raw materials enters the emitter layer, and forms alloys (for example, silver-silicon alloys) with a semiconductor element. Formation regions of the silver-silicon alloys greatly improve contact performance, and distribution regions of the silver-silicon alloys are formed in coverage of the plurality of fingers. The distribution regions of the silver-silicon alloys may be continuous. However, due to migration of silver particles, the silver-silicon alloys may be distributed in a discrete and discontinuous form, or may be distributed in the continuous form and the discrete and discontinuous form. A depth of the distribution regions of the silver-silicon alloys may be adjusted according to a process and elements of the finger raw materials. Generally, a higher glass frit content indicates stronger extension performance of the plurality of fingers.

Still further, the heavily-doped regions are generally formed below the plurality of fingers, but the heavily-doped regions may also be formed below the plurality of busbars. In this embodiment of the present application, preferably, the heavily-doped regions are formed below the plurality of fingers, and the heavily-doped regions are not arranged below the plurality of busbars. The silver-silicon alloys are distributed in the heavily-doped regions. However, sometimes silver-silicon alloys also transversely migrate outside a heavily-doped region to enter an adjacent lightly-doped region. However, a smaller quantity of silver-silicon alloys migrates outside the heavily-doped region, and are generally distributed in a discrete form. A total quantity of the silver-silicon alloys entering the adjacent lightly-doped region is not greater than 10%, and even less than 5% or 2% of a total quantity of silver-silicon alloys. If excessive silver-silicon alloys enter the adjacent lightly-doped region, an adverse effect is brought.

Preferably, the ratio of the width of the plurality of fingers to the width the plurality of initial fingers is greater than 1 and less than or equal to 1.08. In an exemplary embodiment, the ratio may be 1.01, 1.02, 1.03, 1.04, 1.05, 1.06, 1.07, or 1.08.

In an optional embodiment, a metal solid content of the busbar raw materials is less than a metal solid content of the finger raw materials. In an exemplary embodiment, a silver solid content of the busbar raw material is less than a silver solid content of the finger raw material.

In this case, a depth of the plurality of busbars extending toward the emitter layer is less than a depth of the plurality of fingers extending toward the emitter layer. Based on this, the damage degree of the plurality of busbars to the passivation layer can be reduced, thereby ensuring the passivation effect of the passivation layer. Further, when the metal solid content of the finger raw material remains unchanged, compared with a case in the prior art in which the metal solid content of the busbar raw material is the same as the metal solid content of the finger raw material, costs of the busbar raw materials can be reduced, thereby reducing manufacturing costs for manufacturing the solar cell. In addition, it can also be further ensured that the depth of the plurality of fingers extending toward the emitter layer in this embodiment of the present application is substantially the same as or is the same as the depth of the plurality of fingers extending toward the emitter layer in the prior art, thereby ensuring that performance of the plurality of fingers remains unchanged.

In addition, the extending depths of the plurality of busbars and the plurality of fingers may be adjusted by controlling specific elements of the busbar raw material and the finger raw material. In an exemplary embodiment, the adjustment may be performed by increasing a glass frit content or a metal content in the busbar raw material and the finger raw material.

According to a second aspect, an embodiment of the present application further provides a solar cell. Referring to FIG. 2 and FIG. 3, the solar cell includes: a semiconductor substrate 1, an emitter layer 2, a passivation layer 3, an insulating layer 4, a plurality of busbars 5, and a plurality of fingers 6. The emitter layer 2 is formed on a surface of the semiconductor substrate 1, where a conductivity type of the semiconductor substrate 1 is opposite to a conductivity type of the emitter layer 2, and the emitter layer 2 and the semiconductor substrate 1 jointly form a PN junction. The passivation layer 3 is formed on the emitter layer 2. The insulating layer 4 is formed on the passivation layer 3. The plurality of busbars 5 are formed on the insulating layer 4, where the plurality of busbars 5 extend in a first direction and are arranged at intervals in a second direction, the first direction being different from the second direction. The plurality of fingers 6 are formed on the insulating layer 4, where the plurality of fingers 6 extend in the second direction and are arranged at intervals in the first direction, each of the plurality of busbars 5 intersecting with respective fingers 6 of the plurality of fingers 6, and the plurality of fingers 6 penetrating the passivation layer 3 and the insulating layer 4 to be connected to the emitter layer 2. The plurality of busbars 5 extend toward the emitter layer 2. A depth D1 of the plurality of busbars 5 extending into the passivation layer 3 is not greater than 90% of a thickness D2 of the passivation layer 3, and a depth D1 of the plurality of busbars 5 extending into the insulating layer 4 is greater than 20% of a thickness D3 of the insulating layer 4, a depth direction, a thickness direction of the passivation layer 3, and a thickness direction of the insulating layer 4 being consistent with a direction facing the semiconductor substrate 1. In an exemplary embodiment, the depth of the plurality of bus bars 5 extending into the passivation layer 3 may be 0%, 10%, 15%, 30%, 50%, 80%, or 90% of the thickness of the passivation layer 3.

For related information about the semiconductor substrate 1, the emitter layer 2, the passivation layer 3, and the insulating layer 4, reference may be made to the descriptions in the first aspect. Details are not described herein again. Further, the first direction and the second direction may be any two directions parallel to the surface of the semiconductor substrate 1 and different from each other. Preferably, referring to FIG. 3, a first direction A and a second direction B are orthogonal.

In the solar cell provided in this embodiment of the present application, the plurality of busbars 5 are formed on the insulating layer 4. the plurality of busbars 5 extends toward the emitter layer 2. The depth of the plurality of busbars 5 extending into the passivation layer is not greater than 90% of the thickness of the passivation layer 3, and the depth of the plurality of busbars 5 extending into the insulating layer is greater than 20% of the thickness of the insulating layer. In this case, a part of the plurality of busbars 5 (that is, a partial region of the plurality of busbars) after the extension may be formed in only the insulating layer 4, or may be formed in both the insulating layer 4 and the passivation layer 3, but the depth of the plurality of busbars 5 extending into the passivation layer is not greater than 90% of the thickness of the passivation layer 3.

When the part of the plurality of busbars 5 after the extension is formed in only the insulating layer 4, the plurality of busbars 5 does not damage the passivation layer 3, thereby ensuring a passivation effect of the passivation layer 3. Based on this, an open circuit voltage can be improved, thereby reducing or avoiding impact on photoelectric conversion efficiency.

When the part of the plurality of busbars 5 after the extension is formed in both the insulating layer 4 and the passivation layer 3 but the depth of the plurality of busbars 5 extending into the passivation layer is not greater than 90% of the thickness of the passivation layer 3, compared with a case in the prior art in which the plurality of busbars 5 penetrates the passivation layer 3 and is connected to a silicon substrate, a damage degree of the plurality of busbars 5 to the passivation layer 3 is reduced, thereby ensuring a passivation effect of the passivation layer 3. Based on this, an open circuit voltage can be improved, thereby reducing impact on photoelectric conversion efficiency. Further, the plurality of busbars 5 is connected to both the insulating layer 4 and the passivation layer 3. In this case, mechanical properties of the plurality of busbars 5 can be ensured, and a tensile property of the plurality of busbars 5 can be improved. Based on this, a probability that the plurality of busbars 5 is detached from the solar cell can be reduced or eliminated, thereby ensuring quality and performance of the solar cell.

In an embodiment, referring to FIG. 2, a ratio of the depth of the plurality of busbars 5 extending into the passivation layer 3 to the thickness of the passivation layer 3 is greater than or equal to 20%. In an exemplary embodiment, the ratio may be 20%, 30%, 35%, 46%, or 50%. In this case, the plurality of busbars 5 is connected to both the insulating layer 4 and the passivation layer 3. In this case, the mechanical properties of the plurality of busbars 5 can be ensured, and the tensile property of the plurality of busbars 5 can be improved. In this way, the probability that the plurality of busbars 5 is detached from the solar cell is reduced or eliminated, thereby ensuring the quality and the performance of the solar cell.

With reference to the foregoing descriptions, after the plurality of busbars 5 extends in the passivation layer 3, the ratio of the depth of the plurality of busbars 5 extending into the passivation layer 3 to the thickness of the passivation layer 3 is greater than or equal to 20% and less than or equal to 90%.

In an embodiment, the depth of the plurality of busbars extending into the passivation layer is 0. In other words, the plurality of busbars is formed on only the insulating layer. Specifically, the plurality of busbars is formed inside only the insulating layer, or the plurality of busbars is formed on a junction of the insulating layer and the passivation layer, or the plurality of busbars is formed on only a surface of the insulating layer. In this case, the plurality of busbars cannot damage the passivation layer, thereby ensuring the passivation effect of the passivation layer. Based on this, the open circuit voltage can be improved, thereby avoiding impact on the photoelectric conversion efficiency.

In an embodiment, when the thickness of the passivation layer is greater than or equal to 5 nm and less than or equal to 20 nm, the depth of the plurality of busbars extending into the passivation layer is greater than or equal to 1 nm and less than or equal to 18 nm. In an exemplary embodiment, the depth of the plurality of busbars extending into the passivation layer may be 1 nm, 5 nm, 9 nm, 13 nm, 15 nm, or 18 nm.

The depth is greater than or equal to 1 nm. In this case, it can be ensured that the plurality of busbars is connected to both the insulating layer and the passivation layer. Based on this, the mechanical properties of the plurality of busbars can be ensured, and the tensile property of the plurality of busbars can be improved. In this way, the probability that the plurality of busbars is detached from the solar cell is reduced or eliminated, thereby ensuring the quality and the performance of the solar cell. Further, the depth is less than or equal to 18 nm. In this case, the damage degree of the plurality of busbars to the passivation layer can be reduced, thereby ensuring the passivation effect of the passivation layer. In this way, the open circuit voltage is improved, thereby reducing impact on the photoelectric conversion efficiency.

In an embodiment, the emitter layer includes heavily-doped regions and lightly-doped regions. Fingers are connected to the heavily-doped regions, to form alloy regions. A depth of the alloy regions extending into the emitter layer is less than a junction depth of an emitter of the emitter layer, and a depth direction and a junction depth direction of the emitter are consistent with the direction facing the semiconductor substrate.

In an embodiment, when the junction depth of the emitter is greater than or equal to 300 nm and less than or equal to 1200 nm, the depth of the alloy regions extending into the emitter layer is greater than or equal to 50 nm and less than or equal to 1000 nm. In an exemplary embodiment, the depth of the alloy regions extending into the emitter layer may be 50 nm, 80 nm, 100 nm, 260 nm, 390 nm, 550 nm, or 1000 nm. The depth is greater than or equal to 50 nm. In this case, the plurality of fingers and the semiconductor substrate may be allowed to form an alloy, thereby coming into good Ohmic contact.

Preferably, when the junction depth of the emitter is greater than or equal to 300 nm and less than or equal to 1200 nm, the depth of the alloy regions extending into the emitter layer is greater than or equal to 50 nm and less than or equal to 100 nm.

In an embodiment, the thickness of the insulating layer is greater than or equal to 40 nm and less than or equal to 100 nm. In an exemplary embodiment, the thickness of the insulating layer may be 40 nm, 50 nm, 60 nm, 70 nm, 80 nm, 90 nm, or 100 nm.

In an embodiment, referring to FIG. 3, the plurality of busbars 5 includes a busbar connecting line 50 and a plurality of pads 51; the plurality of pads 51 are arranged at intervals on the busbar connecting line 50 in the first direction; and a width of the plurality of pads 51 is greater than a width of the busbar connecting line 50, a width direction of the plurality of pads 51 and a width direction of the busbar connecting line 50 being consistent with the second direction.

For the same quantity of the busbar connecting lines 50, compared with a case in which the width of the busbar connecting line 50 is equal to the width of the plurality of pads 51, a quantity of raw materials used for manufacturing the busbar connecting lines 50 can be reduced while a current collection capability of the busbar connecting lines 50 satisfies an actual requirement, thereby reducing raw material costs. In addition, blocking on the semiconductor substrate 1 by the busbar connecting line 50 can also be reduced, and a light-receiving area of the semiconductor substrate 1 can be increased, thereby improving the photoelectric conversion efficiency of the solar cell. Further, during subsequent manufacturing of the solar cell module, a welding strip needs to be connected to the pad 51. In this case, compared with the case in which the width of the busbar connecting line 50 is equal to the width of the plurality of pads 51, the plurality of welding strips is more easily connected to the plurality of pads 51, thereby reducing manufacturing difficulty, and improving manufacturing efficiency. It should be understood that, for specific structures, manufacturing materials, and the like of the busbar connecting line 50 and the pad 51, reference may be made to the prior art, which are not specifically limited herein.

In an embodiment, referring to FIG. 3, a quantity of the plurality of bus bars 5 is greater than or equal to 8 and less than or equal to 25. In an exemplary embodiment, the quantity of the plurality of busbars 5 may be 8, 10, 12, 15, 18, 20, 22, or 25.

In addition/alternatively, the width of the busbar connecting line 50 is greater than or equal to 35 µm and less than or equal to 60 µm. In an exemplary embodiment, the width of the busbar connecting line 50 may be 35 µm, 40 µm, 45 µm, 52 µm, 55 µm, or 60 µm. The width of the plurality of pads 51 is greater than or equal to 0.6 mm and less than or equal to 1.3 mm. In an exemplary embodiment, the width of the plurality of pads 51 may be 0.6 mm, 0.8 mm, 1.0 mm, 1.16 mm, 1.23 mm, or 1.3 mm.

The quantity of the plurality of busbars 5, the width of the busbar connecting line, and the width of the plurality of pads are controlled, so that an area of blocking the semiconductor substrate 1 by the plurality of busbars 5 can be controlled. In this case, the amount of light injected into the semiconductor substrate 1 can be increased, and the light-receiving area of the semiconductor substrate 1 can be increased, thereby improving solar cell efficiency of the solar cell.

In an embodiment, referring to FIG. 3, a quantity of the plurality of fingers 6 is greater than or equal to 100 and less than or equal to 200. In an exemplary embodiment, the quantity of the plurality of fingers 6 may be 100, 120, 150, 180, 195, or 200. A width of the plurality of fingers 6 is greater than or equal to 20 µm and less than or equal to 45 µm, a width direction of the plurality of fingers 6 being consistent with the first direction. In an exemplary embodiment, the width of the plurality of fingers 6 may be 20 µm, 26 µm, 30 µm, 36 µm, 40 µm, or 45 µm. In this case, a current collection capability of the plurality of fingers 6 can be improved, thereby improving the solar cell efficiency of the solar cell.

According to a third aspect, an embodiment of the present application further provides a solar cell module. The solar cell module includes a plurality of welding strips, and a plurality of solar cells in the foregoing technical solutions that are arranged at intervals, where the plurality of welding strips is connected to respective busbars of a plurality of busbars.

Beneficial effects of the solar cell module provided in this embodiment of the present application are the same as the beneficial effects of the solar cell in the foregoing technical solutions. Details are not described herein again.

In an embodiment, when the plurality of busbars includes a busbar connecting line and a plurality of pads, the plurality of welding strips is arranged on the plurality of pads in the first direction and covers the busbar connecting line; a maximum width of the plurality of welding strips is less than or equal to the width of the plurality of pads; and a width direction of the plurality of welding strips and the width direction of the plurality of pads are consistent with the second direction. In this case, blocking on the semiconductor substrate by the plurality of welding strips can also be reduced, and the light-receiving area of the semiconductor substrate can be increased, thereby improving the photoelectric conversion efficiency of the solar cell.

In an embodiment, a width of the plurality of welding strips is less than or equal to the width of the busbar connecting line, the width direction of the plurality of welding strips and the width direction of the busbar connecting line being consistent with the second direction. In this case, blocking on the semiconductor substrate by the plurality of welding strips can also be reduced, and the light-receiving area of the semiconductor substrate can be increased, thereby improving the photoelectric conversion efficiency of the solar cell.

In an embodiment, a ratio of the width of the plurality of welding strips to the width of the busbar connecting line is greater than or equal to 50% and less than or equal to 90%. In an exemplary embodiment, the ratio may be 50%, 60%, 65%, 70%, 80%, or 90%.

the plurality of welding strips includes a core layer made of a metal material and a solder layer formed on an outer surface of the core layer; in an actual process of welding the plurality of welding strips to the plurality of pads, the solder layer melts due to heat and has flowability; and because the foregoing ratio is greater than or equal to 50% and less than or equal to 90%, flowing solders can be distributed at an interface of the plurality of welding strips and the busbar connecting line, to provide sufficient flow space. In this case, the solders cannot flow to the semiconductor substrate, to prevent the solders from polluting and blocking the semiconductor substrate, thereby ensuring the quality and the performance of the solar cell.

In this embodiment of the present application, a quantity of the plurality of welding strips is the same as a quantity of the busbar connecting lines.

In the descriptions of the foregoing embodiments, the described specific features, structures, materials, or characteristics may be combined in a proper manner in any one or more of the embodiments or examples.

The foregoing descriptions are merely specific embodiments of the present application, but are not intended to limit the protection scope of the present application. Any variation or replacement readily figured out by those of skills in the art within the technical scope disclosed in the present application shall fall within the protection scope of the present application. Therefore, the protection scope of the present application shall be subject to the protection scope of the claims.

## Claims

1. A method for manufacturing a solar cell, comprising:
providing a semiconductor substrate;
forming an emitter layer on a surface of the semiconductor substrate, wherein a conductivity type of the semiconductor substrate is opposite to a conductivity type of the emitter layer;
forming a passivation layer on the emitter layer;
forming an insulating layer on the passivation layer;
forming a plurality of busbars on the insulating layer, wherein the plurality of busbars extend in a first direction and are arranged at intervals in a second direction, the first direction being different from the second direction; and
forming a plurality of fingers on the insulating layer, wherein the plurality of fingers extend in the second direction and are arranged at intervals in the first direction, each of the plurality of busbars intersecting with respective fingers of the plurality of fingers, and the plurality of fingers penetrating the passivation layer and the insulating layer to be connected to the emitter layer,
wherein the plurality of busbars extend toward the emitter layer, a depth of the plurality of busbars extending into the passivation layer being not greater than 90% of a thickness of the passivation layer, and a depth of the plurality of busbars extending into the insulating layer being greater than 20% of a thickness of the insulating layer, a depth direction, a thickness direction of the passivation layer, and a thickness direction of the insulating layer being consistent with a direction facing the semiconductor substrate.

2. The method for manufacturing a solar cell according to claim 1, wherein
a ratio of the depth of the plurality of busbars extending into the passivation layer to the thickness of the passivation layer is greater than or equal to 20%; or
the depth of the plurality of busbars extending into the passivation layer is 0.

3. The method for manufacturing a solar cell according to claim 1, wherein when the thickness of the passivation layer is greater than or equal to 5 nm and less than or equal to 20 nm, the depth of the plurality of busbars extending into the passivation layer is greater than or equal to 1 nm and less than or equal to 18 nm.

4. The method for manufacturing a solar cell according to claim 1, wherein
the plurality of busbars comprises a busbar connecting line and a plurality of pads;
the plurality of pads is arranged at intervals on the busbar connecting line in the first direction; and
a width of the plurality of pads is greater than a width of the busbar connecting line, a width direction of the plurality of pads and a width direction of the busbar connecting line being consistent with the second direction.

5. The method for manufacturing a solar cell according to claim 1, wherein
the forming a plurality of busbars on the insulating layer comprises:
printing busbar raw materials on the insulating layer, to form a plurality of initial busbars; and
processing the plurality of initial busbars, to form the plurality of busbars, wherein
a ratio of a width of the plurality of busbars to a width of the plurality of initial busbars is greater than 1 and less than or equal to 1.1, a width direction of the plurality of busbars and a width direction of the plurality of initial busbars being consistent with the second direction.

6. The method for manufacturing a solar cell according to claim 5, wherein the forming a plurality of fingers on the insulating layer comprises:
printing finger raw materials on the insulating layer, to form initial fingers; and
processing the plurality of initial fingers, to form the plurality of fingers, wherein
a ratio of a width of the plurality of fingers to a width of the plurality of initial fingers is greater than 1 and less than or equal to 1.2, a width direction of the plurality of fingers and a width direction of the plurality of initial fingers being consistent with the first direction.

7. The method for manufacturing a solar cell according to claim 6, wherein a metal solid content of the busbar raw materials is less than a metal solid content of the finger raw materials.

8. A solar cell, comprising:
a semiconductor substrate;
an emitter layer formed on a surface of the semiconductor substrate, wherein a conductivity type of the semiconductor substrate is opposite to a conductivity type of the emitter layer;
a passivation layer formed on the emitter layer;
an insulating layer formed on the passivation layer;
a plurality of busbars formed on the insulating layer, wherein the plurality of busbars extend in a first direction and are arranged at intervals in a second direction, the first direction being different from the second direction; and
a plurality of fingers formed on the insulating layer, wherein the plurality of fingers extend in the second direction and are arranged at intervals in the first direction, the plurality of busbars intersecting with respective fingers of the plurality of fingers, and the plurality of fingers penetrating the passivation layer and the insulating layer to be connected to the emitter layer, wherein
the plurality of busbars extend toward the emitter layer, a depth of the plurality of busbars extending into the passivation layer being not greater than 90% of a thickness of the passivation layer, and a depth of the plurality of busbars extending into the insulating layer being greater than 20% of a thickness of the insulating layer, a depth direction, a thickness direction of the passivation layer, and a thickness direction of the insulating layer being consistent with a direction facing the semiconductor substrate.

9. The solar cell according to claim 8, wherein the emitter layer is formed on a back surface of the solar cell.

10. The solar cell according to claim 8, wherein the emitter layer is formed by doping in an original structure of the semiconductor substrate, or is formed by performing a deposition process on the surface of the semiconductor substrate.

11. The solar cell according to claim 8, wherein
a ratio of the depth of the plurality of busbars extending into the passivation layer to the thickness of the passivation layer is greater than or equal to 20%; or
the depth of the plurality of busbars extending into the passivation layer is 0.

12. The solar cell according to claim 8, wherein when the thickness of the passivation layer is greater than or equal to 5 nm and less than or equal to 20 nm, the depth of the plurality of busbars extending into the passivation layer is greater than or equal to 1 nm and less than or equal to 18 nm.

13. The solar cell according to claim 8, wherein
the thickness of the insulating layer is greater than or equal to 40 nm and less than or equal to 100 nm.

14. The solar cell according to claim 8, wherein the plurality of busbars comprises a busbar connecting line and a plurality of pads;
the plurality of pads are arranged at intervals on the busbar connecting line in the first direction; and
a width of the plurality of pads is greater than a width of the busbar connecting line, a width direction of the plurality of pads and a width direction of the busbar connecting line being consistent with the second direction.

15. The solar cell according to claim 14, wherein
a quantity of the plurality of busbars is greater than or equal to 8 and less than or equal to 25; and/or
the width of the busbar connecting line is greater than or equal to 35 µm and less than or equal to 60 µm, and the width of the plurality of pads is greater than or equal to 0.6 mm and less than or equal to 1.3 mm.

16. The solar cell according to claim 8, 14, or 15, wherein
a quantity of the plurality of fingers is greater than or equal to 100 and less than or equal to 200; and
a width of the plurality of fingers is greater than or equal to 20 µm and less than or equal to 45 µm, a width direction of the plurality of fingers being consistent with the first direction.

17. A solar cell module, comprising a plurality of welding strips, and a plurality of solar cells according to any one of claims 8 to 16 arranged at intervals, wherein
the plurality of welding strips is connected to respective busbars of a plurality of busbars.

18. The solar cell module according to claim 17, wherein when the plurality of busbars comprises a busbar connecting line and a plurality of pads, the plurality of welding strips is arranged on the plurality of pads in the first direction and covers the busbar connecting line;
a maximum width of the plurality of welding strips is less than or equal to the width of the plurality of pads; and
a width direction of the plurality of welding strips and the width direction of the plurality of pads are consistent with the second direction.

19. The solar cell module according to claim 18, wherein a width of the plurality of welding strips is less than or equal to the width of the busbar connecting line, the width direction of the plurality of welding strips and the width direction of the busbar connecting line being consistent with the second direction.

20. The solar cell module according to claim 18 or 19, wherein a ratio of the width of the plurality of welding strips to the width of the busbar connecting line is greater than or equal to 50% and less than or equal to 90%.
